# EUROPEAN PATENT APPLICATION

(11) **EP 2 253 740 A1**
(43) Date of publication of application: **24.11.2010**
(21) Application number: 09702893.0
(22) Date of filing: 08.01.2009
(51) Int. Cl.: C23F 1/18, C23F 1/00

(54) **ETCHANT FOR COPPER OR COPPER ALLOY, LIQUID FOR ETCHING PRETREATMENT, AND ETCHING METHOD**

(30) Priority: 15.01.2008 JP 2008005490; 21.05.2008 JP 2008133499; 05.12.2008 JP 2008310821
(71) Applicant: Mitsubishi Paper Mills Limited, Tokyo 100-0005 (JP)
(72) Inventor: KATO, Makoto, Tokyo 100-0005 (JP); TOYODA, Yuji, Tokyo 100-0005 (JP); NAKAGAWA, Kunihiro, Tokyo 100-0005 (JP); ISHIDA, Mariko, Tokyo 100-0005 (JP); KANEDA, Yasuo, Tokyo 100-0005 (JP)
(74) Representative: Albrecht, Thomas
(86) International application number: PCT/JP2009/050503
(87) International publication number: WO 2009/091012

(57) **Abstract**

An etchant for copper or copper alloy, which contains water as a main component and comprises (1) 1 to 20 mass% of iron (III) chloride and (2) 5 to 100 mass%, based on the iron chloride, of oxalic acid, and an etching method using the above etchant are provided, and the etching method includes pretreatment to be carried out with an aqueous solution containing at least one component selected from a component that dissolves copper or copper alloy and an acid, whereby well yields can be materialized.

## Description

### Technical Field

This invention relates to an etchant for copper or copper alloy suitable for producing high-density printed wiring boards, a liquid for etching pretreatment for copper or copper alloy, and a method of etching copper or copper alloy with the above etchant or liquid for etching pretreatment.

### Background Art

In recent years, the downsizing and functional enhancement of electronic instruments have rapidly progressed, and as regards printed wiring boards to be housed in these instruments, those which have high circuit densities are strongly required.

As a method for producing printed wiring boards, there is widely employed a so-called subtractive method in which a resist pattern is formed on a substrate to which a copper foil has been beforehand bonded, by the method of screen printing, photolithography, etc., and copper foil in an unnecessary portion is removed with an etchant such as an iron (III) chloride aqueous solution, etc., to form a conductor pattern. When a printed wiring board is produced by the above method, however, it is known that there is caused a so-called "side etch" in which an etchant enters around the back surface of a resist pattern, so that the line width of a conductor pattern is narrower than that of the resist pattern. When the side etch takes place, the top width or bottom width of the conductor pattern is decreased, and there is caused a problem that an area necessary for mounting parts cannot be kept, so that it has been difficult to produce a printed wiring board having a high circuit density by the subtractive method.

For the above reason, a so-called additive method in which a circuit is formed by plating is employed for producing printed wiring boards having high circuit densities. However, the additive method essentially has a problem that its cost becomes very high, since it includes complicated steps and is carried out through a plating step that requires a long time period. If only the side etch during etching can be suppressed, the subtractive method can be also employed to produce printed wiring boards having high circuit densities, so that there is strongly demanded the technique of enabling etching in which the side etch is highly suppressed.

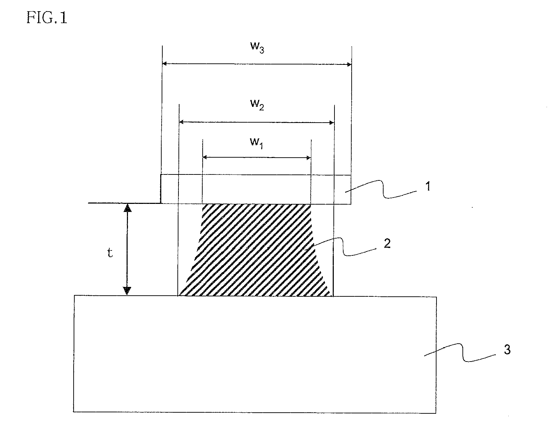

Fig. 1 is a schematic cross-sectional view of a conductor pattern obtained by an etching method. The conductor pattern having a thickness of t is formed from a copper foil 2 on a substrate 3. In a printed wiring board, it is required to keep a proper space in each of the top and bottom of a conductor pattern in order to keep electric insulation from an adjacent conductor. When the top width w₁ or bottom width w₂ is too small, no sufficient electric characteristic can be maintained. Further, when the top width w₁ is too small, it is difficult to mount a component on its surface. When the top width w₁ of a conductor pattern is extremely smaller than the line width w₃ of a resist pattern, there is also caused a problem that the resist pattern 1 peels off the copper foil 2 during etching to break the conductor pattern. Further, when the bottom width w₂ is too small, there is caused a problem that a conductor peels off the substrate 3 to break the conductor pattern. For keeping these problems from taking place, it is required that the top width w₁ and bottom width w₂ of a conductor pattern should not be much smaller than the width w₃ of a resist pattern.

As an etchant for etching copper or copper alloy, an aqueous solution of iron (III) chloride is widely used owing to the advantage of the narrowing of a conductor pattern widths (w₃-w₁ and w₃-w₂) being relatively small, and so on (for example, see Printed Circuit Gijutu Binran, issued by Nikkan Kogyo Shimbun, Ltd., February 28, 1978, pages 649-651). However, so long as any conventional etching technique is relied upon, the absolute value of an etching factor (2t/[w₂-w₁]) obtained by the use of an iron (III) chloride aqueous solution is 5 in an ideal case, in reality, about 4 at best. That is, when a conductor has a thickness of 9 µm, and when etching is carried out until w₃ = w₂ is reached, w₃-w₁ is 3.6 µm even in an ideal case, and it is 4.5 µm or more in reality. When the etch factor is to the above degree, a 40 µm pitch at a copper thickness of 9 µm, i.e., a center-line distance of 40 µm between adjacent conductor patterns is the limitation to the finer-structuring of a wiring, and it has been impossible to form a fine pattern having that or smaller.

US Patent 3,144,368 proposes that an etchant prepared by adding thiourea to iron (III) chloride as a main component is used as a technique of suppressing a side etch. In this technique, not only the capability of suppressing a side etch is insufficient for producing very high-density boards that are demanded in recent years, but also it uses thiourea that is suspected of being carcinogenic, or further it has a serious problem from the viewpoint of industrial hygiene and pollution control that the etchant generates hydrogen sulfide gas that is a toxic and malodorant substance when the etchant is stored or used.

Further, US Patent Application Publication No. 2005/016961 proposes adding an azole compound such as benzotriazole, etc., to an etchant containing an oxidizing metal salt such as iron (III) chloride, etc., and an inorganic acid or organic acid as components. However, not only this technique is also insufficient in capability of suppressing a side etch, but it also has a serious problem from the viewpoint of environmental protection that it uses an azole compound that generally has low biodegradability.

Further, JP 53-30435A proposes an etchant obtained by adding a specific amount of oxalic acid or oxycarboxylic acid to an etchant containing iron (III) chloride or copper (II) chloride as a main component. However, this etchant is not intended for precision processing that has been demanded in recent years. When it is used for producing a printed wiring board having a fine pitch as described above, the etching speed rapidly increases after the etching proceeds to a certain degree, and the line width rapidly decreases, so that it has been practically impossible to control the etching.

### Disclosure of the Invention

### Problems to be Solved by the Invention

It is an object of this invention to provide an etchant for copper or copper alloy, which can get around the problems relating to industrial hygiene, pollution control and environmental protection and which is suitable for producing printed wiring boards having side etches to the least degree and having a high circuit density which are conventionally difficult to materialize with high yields, a liquid for etching pretreatment for copper or copper alloy, and a method of etching copper or copper alloy with the above etchant or liquid for etching pretreatment.

### Means to Solve the Problems

This invention for achieving the above object provides
1. an etchant for copper or copper alloy, which contains water as a main component and comprises (1) 1 to 20 mass% of iron (III) chloride and (2) 5 to 100 mass%, based on the iron chloride, of oxalic acid,
2. a liquid for etching pretreatment for copper or copper alloy, which contains water as a main component and comprises at least one component selected from a component that dissolves copper or copper alloy, and an acid,
3. a liquid for etching pretreatment for copper or copper alloy as recited in the above 2, wherein the acid is monovalent acid,
4. a liquid for etching pretreatment for copper or copper alloy as recited in the above 2, wherein the acid is an aliphatic hydroxycarboxylic acid,
5. a liquid for etching pretreatment for copper or copper alloy as recited in the above 2, which contains a component for dissolving copper or copper alloy and has a pH of 3 or less,
6. a liquid for etching pretreatment for copper or copper alloy as recited in the above 2 or 5, wherein the component that dissolves copper or copper alloy is iron (III) chloride or copper (II) chloride,
7. a liquid for etching pretreatment for copper or copper alloy as recited in any one of the above 2 to 6, which further contains a surfactant,
8. a method of etching copper or copper alloy, which comprises using the etchant recited in the above 1 to etch a material to be etched,
9. a method of etching copper or copper alloy, which comprises using the liquid for etching pretreatment recited in any one of the above 2 to 7 to pretreat a surface of a material to be etched, and then using the etchant recited in the above 1 to etch the material to be etched, and
10. a method of etching copper or copper alloy as recited in the above 9, wherein the material to be etched is washed with water after the pretreatment, and then the etching is carried out.

### Effect of the Invention

According to the etchant for copper or copper alloy in this invention, which contains water as a main component and comprises (1) 1 to 20 mass% of iron (III) chloride and (2) 5 to 100 mass%, based on the iron chloride, of oxalic acid, and the etching method using the above etchant, copper or copper alloy can be etched without causing any heavy side etch. Further, according to the liquid for etching pretreatment for copper or copper alloy in this invention, which contains water as a main component and comprises at least one component selected from a component that dissolves copper or copper alloy, and an acid, and the etching method which implements pretreatment with the above liquid for etching pretreatment, there can be prevented a defect (to be referred to as "remainder defect" hereinafter) in which copper or copper alloy that is a material to be etched remains in the form of a granule or a streak on a resist-pattern-free portion, whereby the yield of products that are produced from them can be improved.

When the acid contained in the liquid for etching pretreatment in this invention is a monovalent acid, the remainder defect can be suppressed to a high degree. When the acid contained in the liquid for etching pretreatment in this invention is an aliphatic hydroxycarboxylic acid, the remainder defect can be also suppressed to a high degree. When the liquid for etching pretreatment in this invention contains a component for dissolving copper or copper alloy and has a pH of 3 or less, the remainder defect can be also suppressed to a high degree. When the liquid for etching pretreatment in this invention contains a surfactant, the effect on the improvement of the product yield can be enhanced.

In the liquid for etching pretreatment in this invention, the component that dissolves copper or copper alloy is iron (III) chloride or copper (II) chloride, so that the yield can be improved without making a side etch bigger or making production steps complicated.

After the pretreatment, the material to be etched is washed and then etched, so that the yield can be improved without making a side etch bigger.

That is, by the etchant for copper or copper alloy, the liquid for etching pretreatment for copper or copper alloy and the method of etching copper or copper alloy in this invention, the production of printed wiring boards having high circuit densities by a subtractive method, which has been conventionally difficult, can be accomplished. Moreover, the etchant of this invention does not generate toxic gases such as hydrogen sulfide, and contains only those components whose waste disposals have been entrenched, so that the disposal thereof after use can be easily and completely done and that it is easy to get around the problems relating to industrial hygiene, pollution prevention and environmental protection. Further, according to a preferred embodiment of this invention, printed wiring boards having high circuit densities can be produced with excellent yields.

### Brief Explanation of Drawings

Fig. 1 is a schematic cross-sectional view of a conductor pattern obtained by an etching method.
Fig. 2 is a schematic drawing of a pattern of a printed wiring board for evaluation of yields.
Fig. 3 is an enlarged schematic drawing of part of a printed wiring board for evaluation of yields.

Symbols in Figs. 1 to 3 will be explained below.
- w₁: Top width of a line in a conductor pattern
- w₂: Bottom width of a line in a conductor pattern
- w₃: Line width of a resist pattern
- t: Thickness of a conductor pattern (copper thickness)
- 1: Resist pattern
- 2: Copper foil (conductor pattern)
- 3: Substrate

### Preferred Embodiments of the Invention

Hereinafter, an etchant for copper or copper alloy will be referred to as "etchant", a liquid for etching pretreatment for copper or copper alloy, as "pretreatment liquid", and a method of etching copper or copper alloy, as "etching method". The etchant, pretreatment liquid and etching method of this invention are to be used for copper or copper alloy. In this invention, copper alloy refers to an alloy having a copper content of 75 mass% or more, and examples thereof include bronze, red brass, cupronickel, etc. Even when the etching method of this invention is applied to an alloy having a copper content of less than 75 mass%, there may not be produced an effect on the decreasing of a side etch.

The etchant of this invention contains iron (III) chloride as the first essential component. The concentration of the iron (III) chloride in the etchant of this invention is required to be 1 to 20 mass% based on the total amount of the etchant, and preferably, to be 2 to 10 mass%. The reason therefor is that when the concentration of the iron (III) chloride is lower than the above, impractically, the etching speed is notably slow and that when the concentration of the iron (III) chloride is higher than the above, the suppression of a side etch is insufficient.

The form of iron (III) chloride to be used for the preparation of the etchant of this invention is not specially limited. Solid of anhydride or hexahydrate may be dissolved for use, or iron (III) chloride in the form of an aqueous solution that is commercially available may be diluted as required for use. Solid iron (III) chloride is generally supplied as a hexahydrate (formula weight 270.30), while the concentration of iron (III) chloride in this invention is calculated using an anhydride (formula weight 162.21) as a standard. For example, when 1.0 kg of an etchant containing 10 mass% of iron (III) chloride in this invention is prepared, iron (III) chloride hexahydrate is to be used in an amount of 1.0 kg x 10 % x (270.30/162.21) = 167 g.

The etchant of this invention contains oxalic acid as the second essential component. The content of oxalic acid is required to be 5 to 100 mass% based on the iron (III) chloride, and preferably, to be 5 to 50 mass%. The reason therefor is that when the content of oxalic acid is smaller than the above, the suppression of a side etch is insufficient, and that when the content of oxalic acid is larger than the above, there may be caused a problem that the etching takes a very long time, or that a fine space is not sufficiently etched.

The form of oxalic acid to be used for the preparation of the etchant of this invention is not specially limited. Solid of an anhydride or dehydrate may be dissolved for use, or oxalic acid in the form of an aqueous solution that is commercially available may be diluted as required for use. Solid oxalic acid is generally supplied as a dehydrate (formula weight 126.07), while the concentration of oxalic acid in this invention is calculated using an anhydride (formula weight 90.04) as a standard. For example, when 1.0 kg of an etchant containing 1.0 mass% of oxalic acid in this invention is prepared, oxalic acid dihydrate is to be used in an amount of 1.0 kg x 1.0 % x (126.07/90.04) = 14 g.

When the etching is carried out using the etchant of this invention, as the method is advantageous for etching for a fine pattern, it is preferred to employ a spray etching method, and it is more preferred to employ a spray etching method in which the spray liquid amount per unit area is 25 to 200 mL/cm²·min. The reason therefor is that when the spray liquid amount is smaller than the above, the etching speed is sometimes greatly decreased, and that when it is larger than the above, a resist pattern is sometimes destroyed to open a line.

Further, when the spray etching is carried out using the etchant of this invention, the pressure (gage pressure, i.e., pressure relative to atmospheric pressure) for supplying the etchant to spray nozzles is preferably 50 to 500 kPa, more preferably 100 kPa to 300 kPa. The reason therefor is that when the above supply pressure is too low, the etching speed is sometimes greatly decreased and that when the supply pressure is too high, a resist pattern is destroyed to open a line.

When the etching is carried out using the etchant of this invention, the temperature of the etchant is preferably 15 to 50°C, more preferably 25 to 45°C. The reason therefor is that when the above temperature is lower than the above, the etching speed in a fine space portion is sometimes greatly decreased, and that when it is higher than the above, the suppression of a side etch is sometimes insufficient.

The etchant of this invention can contain wettability-promoting agents such as a surfactant, an anti-foaming agent, an alcohol, a glycol, etc., while the incorporation of these is not essential.

When the etchant of this invention is used, a remainder defect is liable to take place as compared with a case that uses a conventional etchant. When such a phenomenon takes place in the production of a printed wiring board, there is caused a so-called short-circuit defect, a defect in which conduction takes place between adjacent wiring patterns that should be originally isolated from each other. This defect can be got around by cleaning an environment in which materials to be etched are handled, for example, by handling materials to be etched in a clean environment such as a clean room, or by using, as water to be used in the step of washing, etc., deionized water, water purified with a reverse osmosis membrane, etc., while there is involved a problem that these methods require large equipment, and that the maintenance and operation thereof require large energy and labor.

As means for getting around the above problem, it is effective to treat materials to be etched, before the etching, with an aqueous solution containing an acid as a pretreatment liquid. The reason for an improvement in yields by the treatment with the pretreatment liquid is not clear, while it is assumed that the above pretreatment removes contaminants on the surfaces of the materials to be etched, such as alkaline earth metal ions that form insoluble salts with oxalic acid to inhibit the etching with the etchant of this invention.

The above acid to be contained in the pretreatment liquid is selected from sulfuric acid, phosphoric acid, oxalic acid, succinic acid, maleic acid, etc. Monovalent acid or aliphatic hydroxycarboxylic acid is more preferred in that they highly effectively suppress the short-circuit defect and improve yields. Examples of the monovalent acid include hydrochloric acid, nitric acid, amidosulfuric acid, formic acid, acetic acid, trifluoroacetic acid, benzenesulfonic acid, etc. Further, an aliphatic hydroxycarboxylic acid, i.e., an aliphatic organic compound having a carboxylic acid group and a hydroxyl group can be also preferably used in that it highly effectively suppresses the short-circuit defect and more improves yields. Examples of the aliphatic hydroxycarboxylic acid include lactic acid, glycolic acid, citric acid, isocitric acid, hydroxybutyric acid, malic acid, gluconic acid, etc., and any one of these can be suitably used in this invention. In this invention, the aliphatic hydroxycarboxylic acid can be suitably used regardless of its valence. For attaining a high activity of suppressing the short-circuit defect, the number of carbon atoms per carboxylic acid group is preferably 4 or less.

In this invention, the amount of the acid contained in the pretreatment liquid is preferably 0.5 mass% or more but less than 10 mass%, more preferably 1 to 5 mass%. The reason therefor is that when the acid amount is too small, the effect on the improvement of yields is insufficient, and that when the acid amount is too large, not only it is uneconomical, but also a resist pattern is broken during the pretreatment or etching due to the activity of the acid to easily cause an open defect, i.e., a defect in which metal to be etched in a portion that is originally to be retained is sometimes etched to decrease the yields. Otherwise, even when an open defect is not caused, a small amount of an etchant enters a boundary between a resist pattern and a metal to be etched, and the line form of a conductor pattern sometimes becomes wavy even if the line form of the resist pattern is straightly linear. In this invention, further, one or more acids may be used as acid(s) to be contained in the pretreatment liquid.

As another means for getting around the remainder defect in this invention, it is effective to treat materials to be etched, before the etching, with an aqueous solution containing a component that dissolves copper or copper alloy as a pretreatment liquid. In this invention, the aqueous solution containing a component that dissolves copper or copper alloy refers to an aqueous solution in which copper or copper alloy as a metal to be etched is dissolved by 0.5 µm or more in terms of a thickness when a material to be etched is immersed in the aqueous solution that is a pretreatment liquid for 30 minutes. It is not clear why the yield is improved by treatment with the above pretreatment liquid, while the reason therefor is assumedly that various contaminants present on the surface of a material to be etched are removed together with a metal to be etched on the surface of the material to be etched.

The above pretreatment liquid containing a component that dissolves copper or copper alloy can be selected from a copper (II) chloride aqueous solution, an iron (III) chloride aqueous solution, an aqueous solution mixture of sulfuric acid and hydrogen peroxide, a persulfate aqueous solution, nitric acid, a potassium periodate aqueous solution, etc.

In this invention, the concentration of a component that dissolves copper or copper alloy, contained in the pretreatment liquid, is preferably 0.05 mass% but less than 20 mass%, more preferably 0.5 to 10 mass%. When the above concentration is too low, the effect on the improvement of yields is sometimes not sufficient, and when it is too high, the amount of removal of metal by etching comes to be non-uniform, and even if the line form of a resist pattern is straightly linear, the line form of a conductor pattern sometimes becomes wavy. When the pretreatment liquid of this invention contains both an acid and a component that dissolves copper or copper alloy or contains acid that dissolves copper or copper alloy such as nitric acid, it is preferred to limit the amount of the acid to 5 mass% or less in order to get around a problem that can take place when the amount of the above acid is too large.

It cannot be generally said which is more effective as the pretreatment liquid, the aqueous solution containing an acid or the aqueous solution containing a component that dissolves copper or copper alloy. When the surface of a material to be etched is contaminated to a light degree, however, it is preferred to use an aqueous solution containing an acid alone, since higher yields are obtained when the aqueous solution containing an acid alone is used rather than when an aqueous solution containing only a component that dissolves copper or copper alloy is used. Further, when the surface of a material to be etched is contaminated to a heavy degree, there are cases where almost no effect on the improvement of the yield is produced when the aqueous solution containing an acid alone is used, while there are many cases where yields of some degrees can be obtained when the aqueous solution containing a component that dissolves copper or copper alloy is used, and it is hence preferred to use the aqueous solution containing a component that dissolves copper or copper alloy. The above contamination to a heavy degree refers to a state in which, for example, the surface of a material to be etched has contaminants from the above alkaline earth metal ions, etc., sticking thereto when the material to be etched is left for a long period of time after the formation of a resist pattern.

In this invention, when the pretreatment liquid containing a component that dissolves copper or copper alloy is used, preferably, the pretreatment liquid has a pH of 3 or less, since higher yields can be attained in many cases owing to the pH of 3 or less even when materials to be etched are contaminated to a heavy degree.

It is also preferred to incorporate a surfactant to the pretreatment liquid of this invention since the effect on the improvement of yields is further improved. The above surfactant can be selected from anionic surfactants such as alkyl sulfate, polyoxyethylene alkyl ether sulfate, alkylbenzenesulfonate, fatty acid salt, etc., nonionic surfactants such as polyoxyethylene alkyl ether, a polyoxyalkylene derivative, sorbitan fatty acid ester, polyoxyethylene sorbitan fatty acid ester, polyoxyethylene sorbitol fatty acid ester, glycerin fatty acid ester, polyoxyethylene fatty acid ester, polyoxyethylene hardened castor oil, polyoxyethylene alkylamine, alkylalkanolamide, polyoxyethylene alkyl phenyl ether, a polyoxyethylene-polyoxypropylene block copolymer (so-called pluronic surfactant), fatty acid pentaerythritol ester, etc., cationic surfactants such as alkylamine salt, quaternary ammonium salt, etc., and amphoteric surfactants such as alkylbetaine, etc. In particular, when the pretreatment liquid of this invention has a pH of 5 or less, anionic surfactants, in particular carboxylic acid type surfactants sometimes do not work effectively. Further, cationic surfactants and amphoteric surfactants are sometimes adsorbed on a copper surface to hamper the subsequent etching, so that it is preferred to use nonionic surfactants.

The method for pretreating a material to be etched with the pretreatment liquid of this invention includes a method of immersing the material to be etched in the pretreatment liquid, a method of wiping with a cloth, etc., containing the pretreatment liquid over the surface of the material to be etched, a method of causing the pretreatment liquid to flow over the surface of the material to be etched, a method of spraying the pretreatment liquid to the surface of the material to be etched with a spray nozzle, etc. Of these, the spraying method is preferred since it permits easy continuous treatments and produces a higher effect on the improvement of yields.

In this invention, when an aqueous solution other than the iron (III) chloride aqueous solution or copper (II) chloride aqueous solution is used as the pretreatment liquid, it is preferred to interpose the step of washing with water between the pretreatment liquid step and the etching step. That is because there is sometimes caused a problem that chemical species different from the etchant come into the etchant to make the side etch bigger.

When the iron (III) chloride or copper (II) chloride is used as a pretreatment liquid, the material to be etched may be washed with water between the pretreatment liquid step and the etching step. However, when the iron (III) chloride or copper (II) chloride is used, there is hardly caused a problem that the side etch is made bigger even if the pretreatment liquid comes into the etchant, so that there is an advantage in that the steps are simplified by removing the step of washing with water.

In addition, when the etchant of this invention is disposed of after used, all of iron (II) ion, iron (III) ion, copper (I) ion, copper (II) ion and oxalic acid ion as contained harmful chemical species are precipitation-removed to such an extent that they cause no environmental protection problem, by the step of adding calcium hydroxide to adjust their pHs to weak alkalis which step is a kind of the most basic step of treatment of waste water containing heavy metals. Therefore, the etchant of this invention requires no special waste water treatment steps such as ozone oxidation, etc., which etchants containing an azole compound and an amine compound require.

### Examples

Examples of this invention will be described hereinafter.

### Example 1

### <Preparation of etchant>

Water was added to 27 g (10 g as an anhydride) of a commercially available 40°Be iron (III) chloride aqueous solution (concentration 37 mass%) and 0.70 g (0.50 g as an anhydride) of oxalic acid dihydrate up to a total amount of 1 kg, to prepare an etchant containing 1.0 mass % of iron (III) chloride and 0.050 mass% of oxalic acid.

### <Making of material 1 to be etched>

A positive liquid resist was applied to the surface of a copper-clad laminate obtained by bonding a 1.6 mm thick glass epoxy substrate (FR-4 standard) and a 12 µm thick electro-deposited copper foil to each other, such that a layer on the surface had a dry thickness of 6 µm, followed by drying. Then, an exposure through a pattern having line/space widths of 15 µm/15 µm for evaluation was carried out, and then a resist pattern was formed by development and washing with water to make a material 1 to be etched.

### <Etching>

The above etchant adjusted to 30°C was ejected to the material 1 to be etched by means of a full-cone spray nozzle having an ejection surface diameter of 6.0 cm at a pressure of 150 kPa for supplying a liquid to the nozzle and at an ejection amount of 880 mL/min (per unit area, 31 mL/cm²·min), to carry out etching. In 120 seconds of an ejection time period, the line bottom width (w₂) came to be equal to w₃, or 15 µm. When the ejection time period was set such that it was 1.2 times (144 seconds) as long as the time period that w₂=w₃ took, w₂ was 14 µm and the line top width (w₁) was 8 µm. When the ejection time period was set such that it was 2 times (240 seconds) as long as the time period that w₂=w₃ took, w₂ was 12 µm and w₁ was 8 µm.

### Examples 2 - 8

Etchants containing iron (III) chloride and oxalic acid having concentrations shown in Tables 1 and 2 were prepared in the same manner as in Example 1, and the same materials to be etched as that of Example 1 were spray-etched under ejection conditions as specified. (1) Ejection time periods X (second) it took to reach w₂ = w₃ (15 µm), (2) w₁ and w₂ when the ejection time periods were set to 1.2 times as long as X and (3) w₁ and w₂ when the ejection time periods were set to 2.0 times as long as X were measured. Tables 1 and 2 show the results.

### Comparative Examples 1 - 7

Etchants having compositions and concentrations shown in Tables 2 and 3 were prepared in the same manner as in Example 1, the same resist-pattern-formed substrates as that of Example 1 were spray-etched under ejection conditions as specified, and similar evaluations were made.

**Table 1**

| | Composition and amount of etchant (All amounts shown as anhydrides) (Balance is all water) | Nozzle ejection amount mL/cm² min | Ejection time period (sec) | Line width µm w₁(top)/w₂(bottom) | |
|---|---|---|---|---|---|
| Example 1 | Iron (III) chloride 1.0 mass% Oxalic acid 0.050 mass% | 31 | 120 | w₂ | 15 |
| | | | 144 | w₂ | 14 |
| | | | | w₁ | 8 |
| | | | 240 | w₂ | 12 |
| | | | | w₁ | 8 |
| Example 2 | Iron (III) chloride 1.0 mass% Oxalic acid 1.0 mass% | 93 | 600 | w₂ | 15 |
| | | | 720 | w₂ | 14 |
| | | | | w₁ | 14 |
| | | | 1200 | w₂ | 14 |
| | | | | w₁ | 14 |
| Example 3 | Iron (III) chloride 2.0 mass% Oxalic acid 0.20 mass% % | 31 | 60 | w₂ | 15 |
| | | | 72 | w₂ | 14 |
| | | | | w₁ | 14 |
| | | | 120 | w₂ | 14 |
| | | | | w₂ | 14 |
| Example 4 | Iron (III) chloride 2.0 mass% Oxalic acid 1.0 mass% | 93 | 120 | w₂ | 15 |
| | | | 144 | w₂ | 14 |
| | | | | w₁ | 14 |
| | | | 240 | w₂ | 14 |
| | | | | w₁ | 14 |
| Example 5 | Iron (III) chloride 10.0 mass% Oxalic acid 1.0 mass% | 31 | 30 | w₂ | 15 |
| | | | 36 | w₂ | 13 |
| | | | | w₁ | 13 |
| | | | 60 | w₂ | 13 |
| | | | | w₁ | 13 |
| Example 6 | Iron (III) chloride 10.0 mass% Oxalic acid 5.0 mass% | 78 | 90 | w₂ | 15 |
| | | | 108 | w₂ | 14 |
| | | | | w₁ | 14 |
| | | | 180 | w₂ | 14 |
| | | | | w₁ | 14 |

**Table 2**

| | Composition and amount of etchant (All amounts shown anhydrides) (Balance is all water) | Nozzle ejection amount mL/cm² min | Ejection time period (sec) | Line width µm w₁(top)/w₂(bottom) | |
|---|---|---|---|---|---|
| Example 7 | Iron (III) chloride 20 mass% Oxalic acid 2.0 mass% | 31 | 15 | w₂ | 15 |
| | | | 18 | w₂ | 14 |
| | | | | w₁ | 14 |
| | | | 30 | w₂ | 12 |
| | | | | w₁ | 12 |
| Example 8 | Iron (III) chloride 20 mass% Oxalic acid 10 mass% | 62 | 45 | w₂ | 15 |
| | | | 54 | w₂ | 14 |
| | | | | w₁ | 14 |
| | | | 90 | w₂ | 13 |
| | | | | w₁ | 13 |
| CEx. 1 | Iron (III) chloride 10 mass% Hydrochloric acid (as hydrogen chloride) 0.50 mass% | 31 | 10 | w₂ | 15 |
| | | | 12 | w₂ | 14 |
| | | | | w₁ | 8 |
| | | | 20 | w₂ | 0 |
| | | | | w₁ | 0 |
| CEx. 2 | Iron (III) chloride 10 mass% Hydrochloric acid (as hydrogen chloride) 0.50 mass% Thiourea 1.0 mass% | 62 | 15 | w₂ | 15 |
| | | | 18 | w₂ | 14 |
| | | | | w₁ | 10 |
| | | | 30 | w₂ | 6 |
| | | | | w₁ | 2 |
| CEx. 3 | Iron (III) chloride 10 mass% Hydrochloric acid (as hydrogen chloride) 0.50 mass% Benzotriazole 0.5 mass% | 62 | 30 | w₂ | 15 |
| | | | 36 | w₂ | 14 |
| | | | | w₁ | 10 |
| | | | 60 | w₂ | 6 |
| | | | | w₁ | 2 |
| CEx. 4 | Iron (III) chloride 5 mass% Oxalic acid 0.2 mass% | 31 | 30 | w₂ | 15 |
| | | | 36 | w₂ | 14 |
| | | | | w₁ | 10 |
| | | | 60 | w₂ | 6 |
| | | | | w₁ | 2 |
| CEx. 5 | Iron (III) chloride 5 mass% Oxalic acid 7.5 mass% | 93 | 1800 | Not etchable | |

CEx. = Comparative Example

**Table 3**

| | Composition and amount of etchant (All amounts shown anhydrides) (Balance is all water) | Nozzle ejection amount mL/cm² min | Ejection time period (sec) | Line width µm w₁(top)/w₂(bottom) | |
|---|---|---|---|---|---|
| CEx. 6 | Iron (III) chloride 25 mass% Oxalic acid 2.5 mass% | 31 | 20 | w₂ | 15 |
| | | | 24 | w₂ | 12 |
| | | | | w₁ | 9 |
| | | | 40 | w₂ | 0 |
| | | | | w₁ | 0 |
| CEx. 7 | Iron (III) chloride 42 mass% Oxalic acid 5.8 mass% | 31 | 25 | w₂ | 15 |
| | | | 30 | w₂ | 13 |
| | | | | w₁ | 10 |
| | | | 50 | w₂ | 0 |
| | | | | w₁ | 0 |

| | | | | | |
|---|---|---|---|---|---|
| CEx. = Comparative Example | | | | | |

As is clear in Examples 1 to 8, this invention has enabled the etching that is remarkably less attended with a side etch and has been difficult when conventionally known etchants have been used. Above all, when the etching was carried out under particularly preferred conditions in this invention like Examples 3 to 6, the line width decrease was very small when the etching was continued for a long period of time after a sufficient space width was obtained, and a desired circuit pattern could be remarkably stably formed.

In contrast, with the etchant of Comparative Example 1 that contained no oxalic acid that is an essential component in this invention and the etchants of Comparative Examples 2 and 3 that contained conventionally known additives described in Patent Documents 1 and 2 and the etchant of Comparative Example 4 whose oxalic acid amount was smaller than that proposed by this invention, there were caused side etches bigger than that by the etchant of this invention. Further, with the etchant of Comparative Example 5 that contained oxalic acid in an amount over the amount range defined in this invention, the etching did not proceed. With the etchants of Comparative Example 6 and 7 in which the concentrations of the iron (III) chloride described in Patent Document 3 were higher than that proposed by this invention, the line width sharply decreased after the ejection time period X, and big side etches were caused.

### Example 9

### <Preparation of etchant>

Water was added to 13.5 kg (5.00 kg as an anhydride) of a commercially available 40°Be iron (III) chloride aqueous solution (concentration 37 mass%) and 1.40 kg (1.00 kg as an anhydride) of oxalic acid dihydrate up to a total amount of 100 kg, to prepare 100 kg of an etchant containing 5.0 mass % of iron (III) chloride and 1.0 mass% of oxalic acid.

### <Preparation of pretreatment liquid>

20 Grams of sulfuric acid (concentration 98 mass%) was added to 980 g of water, and they were fully mixed to prepare a pretreatment liquid having a concentration of 2.0 mass%.

### <Making of material 2 to be etched>

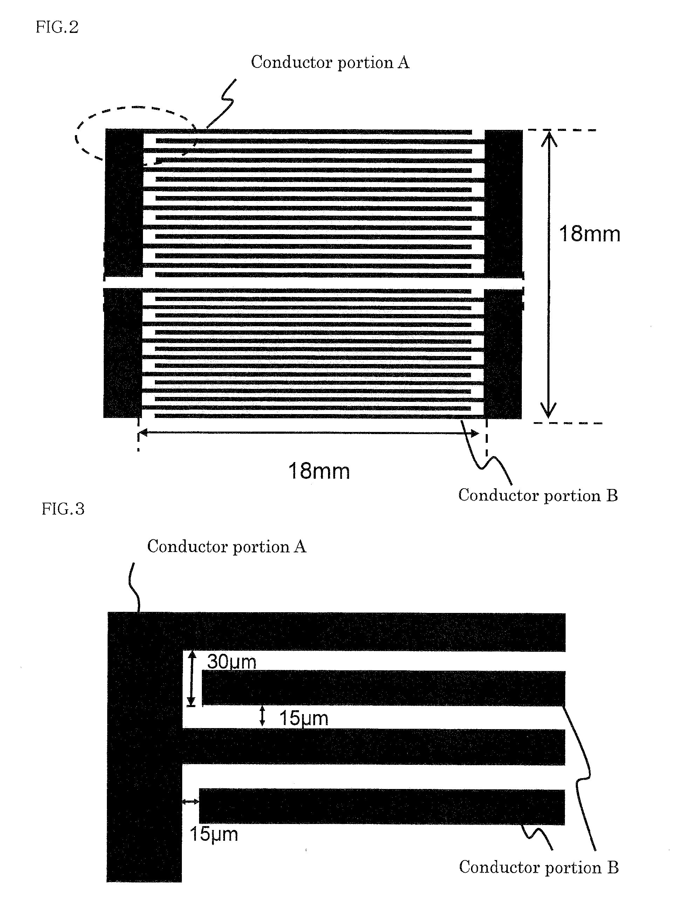

A positive liquid resist was applied to the surface of a copper-clad laminate obtained by bonding a 40 µm thick polyimide insulating material and a 9 µm thick electro-deposited copper foil, such that a layer on the surface had a dry thickness of 6 µm, followed by drying. A resist pattern of 100 blocks having a comb type wiring shown in Fig. 2 each was formed thereon to make a material 2 to be etched. Fig. 3 is an enlarged view of an elliptical portion indicated by a dashed line in Fig. 2. The comb type wiring for evaluation had a constitution having line/space widths of 15 µm/15 µm.

### <Pretreatment>

The above pretreatment liquid was sprayed to the surface of the material 2 to be etched with a spray gun to carry out etching pretreatment.

### <Etching>

The above etchant was ejected to the material 2 to be etched for 90 seconds by means of the same spray etching apparatus as that used in Example 1 to make a printed wiring board for evaluation.

### Examples 10 - 20

Printed wiring boards for evaluation were made in the same manner as in Example 9 except that the composition of the pretreatment liquid was changed as shown in Table 4, and yields were evaluated.

### Example 21

A printed wiring board for evaluation was made in the same manner as in Example 9 except that the pretreatment was not carried out, and a yield was evaluated.

### Examples 22 - 23

Printed wiring boards for evaluation were made in the same manner as in Example 9 except that the composition of the pretreatment liquid was changed as shown in Table 4, and yields were evaluated.

### <Evaluations>

Blocks of each of the printed wiring boards for evaluation, made in Example 9 to 23, were inspected for conduction between a conductor portion A and a conductor portion B, a block having no conduction between the conductor portion A and the conductor portion B was taken as a good item, a block having the conduction was taken as a defective item, and the number of good items/(number of good items + number of defective items) was calculated to determine a yield (%). The conduction between the conductor portion A and the conductor portion B means that a short-circuit defect has taken place due to the presence of a remainder defect in a space portion between these two conductor portions, and when printed wiring boards for practical use are produced under the same conditions, similar short-circuit defects are liable to take place. Defects that take place in the circuit pattern of a printed wiring board include not only a short-circuit defect but also an open defect, that is, a defect of discontinuity between two points that are to be originally in continuity. As a result of an optical inspection, however, the rate of occurrence of open defects under the etching conditions of Examples 9 to 23 is significantly small as compared with the rate of occurrence of short-circuit defects, and it has been confirmed that it has no substantial influence on the results of this evaluation of yields. In any one of Examples 9 to 23, the line top width w₁ and the line bottom width w₂ were in the range of 12 to 15 µm, and the etching that was less attended with a side etch was carried out.

**Table 4**

| | Composition and amount of pretreatment liquid (All amounts shown as anhydrides) (Balance is all water) | Yield (%) |
|---|---|---|
| Example 9 | Sulfuric acid 2.0 mass% | 20 |
| Example 10 | Phosphoric acid 2.0 mass% | 18 |
| Example 11 | Oxalic acid 2.0 mass% | 16 |
| Example 12 | Hydrochloric acid 2.0 mass% | 51 |
| Example 13 | Acetic acid 2.0 mass% | 47 |
| Example 14 | Amidosulfuric acid 2.0 mass% | 43 |
| Example 15 | Citric acid 2.0 mass% | 73 |
| Example 16 | Gluconic acid 2.0 mass% | 70 |
| Example 17 | Lactic acid 2.0 mass% | 65 |
| Example 18 | Sulfuric acid 2.0 mass% Polyoxyethylene lauryl ether (HLB=12.1) 0.05 mass% | 44 |
| Example 19 | Acetic acid 2.0 mass% Polyoxyethylene lauryl ether (HLB=12.1) 0.05 mass% | 81 |
| Example 20 | Citric acid 2.0 mass% Polyoxyethylene lauryl ether (HLB=12.1) 0.05 mass% | 96 |
| Example 21 | Nil | 3 |
| Example 22 | Water alone | 5 |
| Example 23 | Polyoxyethylene lauryl ether (HLB=12.1) 0.05 mass% | 6 |

As is seen from comparisons of Examples 9 to 20 with Examples 21 to 23, when the materials to be etched are pretreated with the pretreatment liquids containing acids before the etching with the etchant containing iron (III) chloride and oxalic acid, the occurrence of the short-circuit defect can be suppressed, and the yields can be hence improved.

As is seen from the comparisons of Examples 9 to 11 with Examples 12 to 15, monovalent acids are preferred as an acid in the pretreatment liquid, and these serve to produce an high effect on the suppression of the short-circuit defect.

Further, as is seen from the comparisons of Examples 9 to 14 with Examples 15 to 17, aliphatic hydroxycarboxylic acids are more preferred as an acid in the pretreatment liquid, and these serve to produce a higher effect on the suppression of the short-circuit defect.

Further, as is also seen from the comparisons of Example 9 with Example 18, Example 13 with Example 19 and Example 15 with Example 20, the effect on the suppression of the short-circuit defect can be further enhanced by incorporating the surfactant to the pretreatment liquid of this invention. This is an effect that can be produced only when the surfactant is incorporated into the pretreatment liquid containing the acid, and as is seen from Example 23, when the pretreatment liquid containing the surfactant alone is used, there can be produced no high effect on the suppression of the short-circuit defect.

### Example 24

The pretreatment liquid of Example 20 was sprayed to the material 2 to be etched, and after lightly squeezed, the material 2 to be etched was measured for a mass. As a result, it was found that 1.8 g of a prewashing liquid adhered per material 2 to be etched. Therefore, as a simulation test corresponding to a case where the etching is carried out without washing with water after the treatment with the pretreatment liquid, the pretreatment liquid in an amount of 1,800 g corresponding to the amount included in the etchant to be used for etching 1,000 materials 2 to be etched was added to the etchant, and the etching was carried out.

### <Evaluation>

When the printed wiring boards for evaluation, made in Examples 20 and 24, were measured for conductor pattern top width w₁/conductor pattern bottom width w₂, the printed wiring board for evaluation in Example 20 showed 12.6 µm/14.2 µm and the printed wiring board for evaluation in Example 24 showed 11.4 µm/13.8 µm.

### Example 25

As a simulation test corresponding to a case where the etching is carried out after washing with water after the treatment with the pretreatment liquid containing an acid, the etching was carried out with the etchant of Example 9 after 1,800 g of deionized water was added thereto. In this case, the w₁/w₂ were 12.3 µm/13.9 µm.

As is clear from the comparison of Example 24 with Example 25, when the etching is carried out after washing with water after the treatment with the pretreatment liquid containing an acid, the etching can get around an increase in a side etch caused by the inclusion of the pretreatment liquid in the etchant, and it can be stably carried out.

### Example 26

### <Preparation of pretreatment liquid>

167 g of hydrogen peroxide (concentration 30 mass%) and 105 g of sulfuric acid (concentration 95 %) were added to 728 g of water, and they were fully mixed to prepare a pretreatment liquid having a hydrogen peroxide concentration of 5.0 mass% and a sulfuric acid concentration of 10 mass%. This pretreatment liquid was measured for a pH with a glass electrode pH meter to show less than 1.

Further, the copper-clad laminate used in Example 9 was immersed in this pretreatment liquid for 30 minutes, and then it was measured for a copper thickness decrement to show 6.3 µm.

### <Pretreatment>

As a material to be etched which was contaminated to a light degree, the material 2 to be etched in Example 9 was used as it was. As a material to be etched which was contaminated to a heavy degree, there was used a material 3 to be etched, which was prepared by leaving the material 2 to be etched in Example 9 on a laboratory table for 3 days without taking any antipollution measure. The pretreatment liquid was sprayed to each material to be etched with a spray gun for 20 seconds to carry out etching pretreatment. The materials to be etched after the pretreatment were washed with tap water, then washed with deionized water and then kept in deionized water to be used in the subsequent etching.

### <Etching>

The same etchant as that in Example 9 was ejected to the pretreated materials 2 and 3 to be etched, with a spray etching apparatus for 90 seconds to make printed wiring boards for evaluation.

### Examples 27 - 42

Printed wiring boards for evaluation were made in the same manner as in Example 1 except that the composition of the pretreatment liquid was changed as shown in Table 1. These pretreatment liquids were measured for pHs and copper dissolved amounts, and they were as shown in Table 5.

### Example 43

Printed wiring boards for evaluation were made in the same manner as in Example 26 except that the pretreatment liquid was changed to water.

### Example 44

Printed wiring boards for evaluation were made in the same manner as in Example 26 except that the pretreatment was not carried out.

### Comparative Example 8

Printed wiring boards for evaluation were made in the same manner as in Example 44 except that the etchant contained no oxalic acid and that the time period for the ejection of the etchant was changed to 40 seconds.

### Comparative Example 9

Printed wiring boards for evaluation were made in the same manner as in Example 26 except that the etchant contained no oxalic acid and that the time period for the ejection of the etchant was changed to 40 seconds.

### <Evaluation>

The printed wiring board made in Examples 26 to 44 and Comparative Examples 8 and 9 were evaluated in the same manner as in Examples 9 to 23 to determine yields. As an optical inspection, the rate of occurrence of open defects under the etching conditions of Examples 26 to 44 is significantly small as compared with the rate of occurrence of short-circuit defects, and it has been confirmed that it has no substantial influence on the results of this evaluation. Further, in any one of Examples 26 to 44, the line top width w₁ and the line bottom width w₂ were in the range of 12 to 15 µm, and the etching that was less attended with a side etch was carried out.

Further, with regard to straightly linear portions of the resist patterns, the marginal form of each conductor pattern formed was observed through a microscope, and classified to five ratings; good, kind of good, normal, rather defective and defective, including good when it is very straightly linear and defective when it was clearly caused to be wavy.

**Table 5**

| | Composition and amount of pretreatment liquid (All amounts shown as anhydrides) (Balance is all water) | pH | Dissolved amount (µm) |
|---|---|---|---|
| Example 26 | Hydrogen peroxide 5.0 mass% Sulfuric acid 10 mass% | <1 | 6.3 |
| Example 27 | Sodium persulfate 5.0 mass% Sulfuric acid 10 mass% | <1 | 4.1 |
| Example 28 | Iron (III) chloride 0.030 mass% Hydrochloric acid 0.0020 mass% | 4 | 0.6 |
| Example 29 | Iron (III) chloride 0.050 mass% Hydrochloric acid 0.0040 mass% | 3 | 0.7 |
| Example 30 | Iron (III) chloride 0.50 mass% Hydrochloric acid 0.040 mass% | <1 | 6.3 |
| Example 31 | Iron (III) chloride 5.0 mass% Hydrochloric acid 0.40 mass% | <1 | 9.0 |
| Example 32 | Iron (III) chloride 20 mass% Hydrochloric acid 1.6 mass% | <1 | 9.0 |
| Example 33 | Copper (II) chloride 0.030 mass% Hydrochloric acid 0.0080 mass% | 4 | 0.5 |
| Example 34 | Copper (II) chloride 0.050 mass% Hydrochloric acid 0.015 mass% | 3 | 0.6 |
| Example 35 | Copper (II) chloride 0.50 mass% Hydrochloric acid 0.15 mass% | <1 | 5.6 |
| Example 36 | Copper (II) chloride 5.0 mass% Hydrochloric acid 1.5 mass% | <1 | 9.0 |
| Example 37 | Copper (II) chloride 20 mass% Hydrochloric acid 6.0 mass% | <1 | 9.0 |
| Example 38 | Iron (III) chloride 0.030 mass% Hydrochloric acid 0.0020 mass% Polyoxyethylene lauryl ether (HLB=12.1) 0.050 mass% | 4 | 0.6 |
| Example 39 | Iron (III) chloride 5.0 mass% Hydrochloric acid 0.40 mass% Polyoxyethylene lauryl ether (HLB=12.1) 0.050 mass% | <1 | 9.0 |
| Example 40 | Hydrochloric acid 2.0 mass% | <1 | 0.0 |
| Example 41 | Polyoxyethylene lauryl ether (HLB=12.1) 0.050 mass% | 6 | 0.0 |
| Example 42 | Hydrochloric acid 2.0 mass% Polyoxyethylene lauryl ether (HLB=12.1) 0.050 mass% | <1 | 0.0 |
| Example 43 | Water alone | 6 | 0.0 |
| Example 44 | Nil | | |
| Comparative Example 8 | Nil | | |
| Comparative Example 9 | Hydrogen peroxide 5.0 mass% Sulfuric acid 10 mass% | <1 | 6.3 |

**Table 6**

| Yields (%) | | | Marginal form of conductor pattern |
|---|---|---|---|
| | Pretreatment made immediately after formation of resist pattern | Pretreatment made 3 days after formation of resist pattern | |
| Example 26 | 90 | 78 | Kind of good |
| Example 27 | 89 | 79 | Kind of good |
| Example 28 | 16 | 12 | Good |
| Example 29 | 25 | 21 | Good |
| Example 30 | 76 | 69 | Good |
| Example 31 | 93 | 88 | Good |
| Example 32 | 86 | 79 | Normal |
| Example 33 | 15 | 10 | Good |
| Example 34 | 30 | 21 | Good |
| Example 35 | 75 | 68 | Good |
| Example 36 | 90 | 87 | Good |
| Example 37 | 88 | 80 | Normal |
| Example 38 | 25 | 22 | Good |
| Example 39 | 97 | 95 | Good |
| Example 40 | 48 | 3 | Good |
| Example 41 | 5 | 0 | Good |
| Example 42 | 72 | 8 | Good |
| Example 43 | 5 | 0 | Good |
| Example 44 | 2 | 0 | Good |
| Comparative Example 8 | 0 | 0 | Defective |
| Comparative Example 9 | 0 | 0 | Defective |

As is seen from Examples 26 to 39, the material to be etched is treated with the pretreatment liquid containing the component that dissolves copper or copper alloy before it is etched with the etchant containing iron (III) chloride and oxalic acid, whereby the occurrence of the short-circuit defect can be suppressed, and the yield can be improved.

In contrast, in Example 43 that used water as the pretreatment liquid and Example 44 that employed no pretreatment, the short-circuit defect occurred as compared with Examples 26 to 39, and the yields were low. Further, as is seen from the comparisons of Examples 26 to 39 with Examples 40 and 42, when the aqueous solution containing an acid having no capability of dissolving copper or copper alloy was used as the pretreatment liquid, the effect on the improvement of the yield could be produced with regard to the material 2 to be etched which was contaminated to a light degree, while the effect on the improvement of the yield was insufficient with regard to the material 3 to be etched which was contaminated to a heavy degree. In Comparative Example 8 in which the etching was carried out with an iron (III) chloride aqueous solution containing no oxalic acid and Comparative Example 9 in which the etching was carried out with an iron (III) chloride aqueous solution containing no oxalic acid after the treatment with the pretreatment liquid containing the component that dissolves copper or copper alloy, extreme side etches and many consequent open defects took place, and no printed wiring boards having fine patterns could be produced (yield 0 %).

In Examples 26 to 39, as is seen from the comparison of Example 28 with Example 29 and the comparison of Example 33 with Example 34, the improvement of the yield can be highly realized by using the acidic solution having a pH of 3 or less as the pretreatment liquid.

Further, as is seen from the comparison of Example 28 with Example 38 and the comparison of Example 31 with Example 39, the improvement of yields can be highly realized by incorporating the surfactant into the pretreatment liquid of this invention containing the component that dissolves copper or copper alloy as compared with a case where the pretreatment liquid containing no surfactant is used. However, as is seen from Example 41, when a surfactant alone is used as the pretreatment liquid, the effect on the improvement of the yield cannot be produced, and as is seen from Example 42, when a solution obtained by incorporating a surfactant into an acid having a pH of 3 and having no capability of dissolving copper or copper alloy is used as the pretreatment liquid, a high effect is produced on the improvement of the yield with regard to the material 2 to be etched that is contaminated to a light degree, while the effect on the improvement of the yield is insufficient with regard to the material 3 to be etched which is contaminated to a heavy degree.

Of Examples 26 to 39, Examples 26 and 27 in which the pretreatment liquids contained 10 mass% or more of an acid and Examples 32 and 37 in which the pretreatment liquid contained 20 mass% or more of a component capable of dissolving copper or copper alloy tended to cause wavy margins of conductor patterns even if the margin of the resist pattern was straightly linear.

### Example 45

The pretreatment liquid of Example 26 was sprayed to the material 2 to be etched which was contaminated to a light degree, and after lightly squeezed, the material 2 to be etched was measured for a mass. As a result, it was found that 1.8 g of a treatment adhered per material 2 to be etched. Therefore, as a simulation test corresponding to a case where the etching is carried out without washing with water after the treatment with the pretreatment liquid, the prewashing liquid of Example 26 in an amount of 1,800 g corresponding to the amount included in the etchant to be used for etching 1,000 materials 2 to be etched was added to the etchant of Example 9, and a printed wiring board for evaluations was made in the same manner as in Example 26 with regard to any other portion. When the above printed wiring board for evaluation was measured for conductor pattern top width w₁/conductor pattern bottom width w₂, it showed 11.4 µm/13.9 µm as compared with the 12.6 µm/14.2 µm of the printed wiring board of Example 26.

### Example 46

As a simulation test corresponding to a case where the etching is carried out after washing with water after the treatment with the pretreatment liquid containing an acid, a printed wiring board for evaluation was made in the same manner as in Example 26 except that 1,800 g of deionized water was added to the etchant of Example 9. The printed wiring board for evaluation made in this Example had w₁/w₂ widths of 12.2 µm/13.8 µm.

### Examples 47 and 48

Printed wiring boards were made in the same manner as in Examples 31 and 36 except that the etching was carried out after 1,800 g of the respective pretreatment liquids were added like the pretreatment liquid was added in Example 45. The printed wiring boards for evaluation made in these Examples had w₁/w₂ widths of 12.4 µm/13.9 µm and 12.3 µm/14.0 µm.

The w₁ and w₂ of the printed wiring boards for evaluation made in Examples 47 and 48 are nearly the same as those in Example 46, and it is seen that when the iron (III) chloride aqueous solution or copper (II) chloride aqueous solution is used as the pretreatment liquid, the influence such as an increase in a side etch, etc., is hardly caused even if the washing with water after the pretreatment step is omitted. In contrast, when the pretreatment liquid is not any iron (III) chloride aqueous solution or copper (II) chloride aqueous solution like Example 45, it is seen that the thus-made printed wiring board for evaluation suffers a more or less big side etch.

### Industrial Utility

The etchant of this invention can be suitably applied not only to the production of printed wiring boards, but also to cases where it is required to control the etching of copper or copper alloy to high degrees in industrial fields of productions of lead frames, precision gears, precision flat springs, discs and stripes for encoders, various stencils and others.

## Claims

1. An etchant for copper or copper alloy, which contains water as a main component and comprises (1) 1 to 20 mass% of iron (III) chloride and (2) 5 to 100 mass%, based on the iron chloride, of oxalic acid.

2. A liquid for etching pretreatment for copper or copper alloy, which contains water as a main component and comprises at least one component selected from a component that dissolves copper or copper alloy, and an acid.

3. The liquid for etching pretreatment for copper or copper alloy as recited in claim 2, wherein the acid is monovalent acid.

4. The liquid for etching pretreatment for copper or copper alloy as recited in claim 2, wherein the acid is an aliphatic hydroxycarboxylic acid.

5. The liquid for etching pretreatment for copper or copper alloy as recited in claim 2, which contains a component for dissolving copper or copper alloy and has a pH of 3 or less.

6. The liquid for etching pretreatment for copper or copper alloy as recited in the above 2 or 5, wherein the component that dissolves copper or copper alloy is iron (III) chloride or copper (II) chloride.

7. The liquid for etching pretreatment for copper or copper alloy as recited in any one of claims 2 to 6, which further contains a surfactant.

8. A method of etching copper or copper alloy, which comprises using the etchant recited in claim 1 to etch a material to be etched.

9. A method of etching copper or copper alloy, which comprises using the liquid for etching pretreatment recited in any one of claims 2 to 7 to pretreat a surface of a material to be etched, and then using the etchant recited in the above 1 to etch the material to be etched.

10. The method of etching copper or copper alloy as recited in claim 9, wherein the material to be etched is washed with water after the pretreatment, and then the etching is carried out.
